# EUROPÄISCHE PATENTSCHRIFT

(11) **EP 1 168 903 B1**
(45) Veröffentlichungstag und Bekanntmachung des Hinweises auf die Patenterteilung: **26.11.2008**
(21) Anmeldenummer: 01107126.3
(22) Anmeldetag: 22.03.2001
(51) Int. Cl.: H05K 5/02, B60R 16/02, H05K 5/00

(54) **Gehäuseeinheit für elektrische Komponenten zum Einsatz im Kraftfahrzeugbereich**
Casing for electrical components for use in the automobile industry
Boîtier pour composants électriques utilisé dans l'industrie automobile

(30) Priorität: 28.06.2000 DE 10031477
(43) Veröffentlichungstag der Anmeldung: 02.01.2002
(73) Patentinhaber: Pierburg GmbH, 41460 Neuss (DE)
(72) Erfinder: Sinn, Walther, Dr., 47877 Willich (DE)
(74) Vertreter: Patentanwälte ter Smitten

(56) Entgegenhaltungen:
- EP-A- 0 113 073
- EP-A- 0 484 288
- CH-A- 642 213
- DE-A- 4 210 979

## Beschreibung

Die Erfindung betrifft eine Gehäuseeinheit für elektrische Komponenten zum Einsatz im Kraftfahrzeugbereich, mit einem Gehäuseteil, das durch einen Gehäusedeckel abgedichtet verschließbar ist, wobei das Gehäuseteil oder der Gehäusedeckel ein nach außen gerichtetes, elektrisches Anschlusselement aufweist.

Derartige Gehäuseeinheiten sind hinlänglich bekannt. Bei insbesondere im Fahrzeugmotorraum verbauten elektrischen Komponenten, die in Gehäuseeinheiten angeordnet sind, ist heute eine hohe Schutzart wie beispielsweise Dampfstrahlbeständigkeit bei hohem Druck, gefordert. Deshalb werden die Trennflächen zwischen dem Gehäuseteil und dem Gehäusedeckel mit einem Dichtmaterial versehen. Besonders vorteilhaft hat sich dabei in der Großserie die Verwendung von pastösen Nassdichtungen erwiesen, die unmittelbar vor Montage des Gehäusedeckels auf das Gehäuseteil wurstförmig auf die Dichtflächen aufgetragen werden. Beim Schließen der Gehäuseeinheit wird bereits bei der ersten vollflächigen Berührung des Gehäusedeckels mit der Dichtmasse eine Luftdichtheit des Innenraums der Gehäuseeinheit erreicht. Aufgrund des wurstförmigen Dichtungsauftrags muss der Gehäusedeckel jedoch noch näher zum Gehäuse positioniert werden. Dabei wird das eingeschlossene Luftvolumen komprimiert. Der entstehende Überdruck ist dabei abhängig von der Dicke des Dichtungsauftrages und der Fläche des Deckels. Dieser Überdruck kann beim Montageprozess zu einem lokalen Aufbruch der Dichtung führen, durch den dann ein Druckausgleich stattfindet. Aufgrund der pastösen Einstellung des Dichtmaterials schließt sich dieser Durchbruch nach der Montage dann jedoch nicht sicher, so dass eine bleibende Leckage entstehen kann.

Darüber hinaus ist aus der DE 42 10 979 A1 eine Gehäuseeinheit für elektrische Komponenten bekannt, bei der eine Entlüftungsöffnung vorgesehen ist, die einen für die Anwendung notwendigen Luftaustausch, auch während des Betriebes, gewährleisten soll. Diese Gehäuseeinheit weist jedoch kein nach außen gerichtetes Anschlusselement auf.

Hiervon ausgehend liegt der Erfindung die Aufgabe zugrunde, eine gattungsgemäße Gehäuseeinheit dahingehend zu verbessern, dass der oben genannte Nachteil vermieden wird.

Diese Aufgabe wird bei einer gattungsgemäßen Gehäuseeinheit dadurch gelöst, dass in dem Anschlusselement zumindest eine Entlüftungsöffnung angeordnet ist. Durch diese Entlüftungsöffnung kann der Gehäusedeckelmontage aufgebaute Überdruck gezielt abgeführt werden, ohne dass es zu einem Aufbruch der Dichtungsmasse kommt. Das elektrische Anschlusselement wird bei einer späteren Montage der Gehäuseeinheit beispielsweise im Motorraum und dem damit verbundenen elektrischen Anschluss durch ein entsprechendes Steckerelement abgedichtet verschlossen, so dass die Entlüftungsbohrung nicht separat abgedichtet werden muss.

Ein Ausführungsbeispiel der Erfindung ist in den Zeichnungen dargestellt und wird nachfolgend beschrieben.

Die Zeichnung zeigt:
- Figur 1: eine geschnittene Teilansicht einer Gehäuseeinheit,
- Figur 2: eine geschnittene Teilansicht eines Gehäusedeckels mit elektrischem Anschlusstecker.

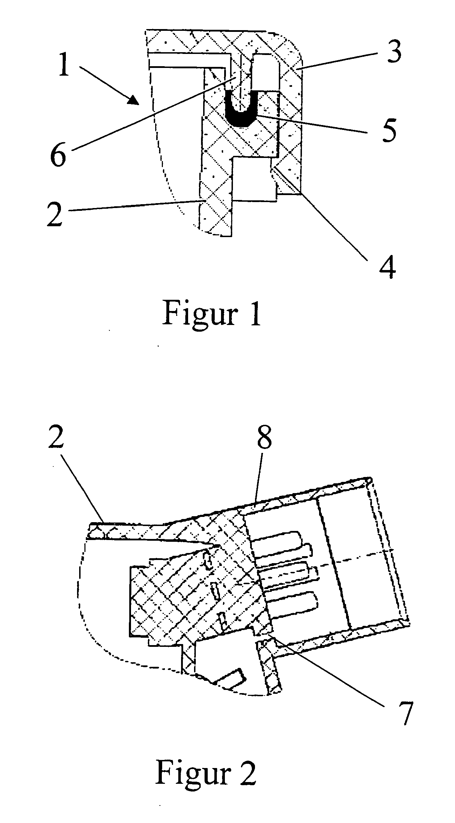

Figur 1 zeigt eine geschnittene Teilansicht einer Gehäuseeinheit 1 mit einem Gehäuseteil 2 und einem auf dem Gehäuseteil 2 angeordneten Gehäusedeckel 3. Der Gehäusedeckel 3 ist im folgenden Ausführungsbeispiel durch ein bekanntes Rastelement 4 mit dem Gehäuseteil 2 verbunden. Aufgrund der erhöhten Schutzanforderungen an die Gehäuseeinheit 1 bei Anbringung in beispielsweise einem nicht dargestellten Motorraum, wurde das Gehäuseteil 2 vor Montage des Gehäusedeckels 3 mit einer wurstförmig aufgetragenen pastösen Nassdichtung 5 versehen, wodurch schon bei einer ersten vollflächigen Berührung mit einer Deckelfeder 6 der Innenraum der Gehäuseeinheit 1 luftdicht abgeschlossen wird und bei einem weiteren Eindringen der Deckelfeder 6 ein Überdruck aufgebaut wird, der über eine Figur 2 dargestellte Entlüftungsöffnung entweichen kann. Gleichzeitig erfolgt im vorliegenden Ausführungsbeispiel eine nicht-lösbare Verbindung von Gehäuseteil 2 mit Gehäusedeckel 3 durch die Dichtung 5.

Figur 2 zeigt in geschnittener Teilansicht das Gehäuseteil 2 mit einem elektrischen Anschlusselement 8, das auf bekannte Weise mit einem elektrischen Stecker abgedichtet verbindbar ist. Im Anschlusselement 8 ist eine Entlüftungsöffnung 7 angeordnet, durch die während des Montagevorganges des Gehäusedeckels 3 auf das Gehäuseteil 2 der Überdruck im Innenraum der Gehäuseeinheit 1 entweichen kann, so dass ein ungewünschter Aufbruch der Dichtung 5 während des Montagevorganges verhindert wird.

Es sollte deutlich sein, dass das elektrische Anschlusselement 8 natürlich auch am Gehäusedeckel 3 angeordnet sein kann.

## Patentansprüche

1. Gehäuseeinheit für elektrische Komponenten zum Einsatz im Kraftfahrzeugbereich, mit einem Gehäuseteil, das durch einen Gehäusedeckel abgedichtet verschließbar ist, wobei das Gehäuseteil oder der Gehäusedeckel ein nach außen gerichtetes, elektrisches Anschlusselement aufweist, **dadurch gekennzeichnet, dass** in dem Anschlusselement 8 zumindest eine Entlüftungsöffnung 7 angeordnet ist, derart, dass durch ein entsprechendes Steckerelement die Entlüftungsbohrung 7 im montierten Zustand abgedichtet verschlossen ist.

## Claims

1. A casing for electric components for use in the field of motor vehicles, comprising a casing part that may be closed with a casing lid in a sealed manner , the casing part or casing lid having an outward directed electric connector element, **characterized in that** at least one vent opening (7) is provided in the connector element (8) such that, in the mounted condition, the vent opening (7) is closed in a sealed manner by a corresponding plug element.

## Revendications

1. Boîtier pour composants électriques utilisé dans le domaine des véhicules, comprenant un partie du boîtier fermable de manière étanche par un couvercle de boîtier, la partie du boîtier ou le couvercle de boîtier comprenant un élément connecteur électrique orienté vers l'extérieur, **caractérisé en ce que** l'élément connecteur (8) est prévu d'au moins une ouverture de ventilation (7) de sorte que, en état assemblé, l'ouverture de ventilation (7) est fermée de manière étanche par un élément fiche correspondant.
